# EUROPÄISCHE PATENTSCHRIFT

(11) **EP 3 080 819 B1**
(45) Veröffentlichungstag und Bekanntmachung des Hinweises auf die Patenterteilung: **13.11.2019**
(21) Anmeldenummer: 15708461.7
(22) Anmeldetag: 25.02.2015
(51) Int. Cl.: H01B 3/52, H01B 7/29, H02K 3/02, H02K 3/40, H05K 9/00, H02K 3/30

(54) **GLIMMSCHUTZSYSTEM, INSBESONDERE AUSSENGLIMMSCHUTZSYSTEM FÜR EINE ELEKTRISCHE MASCHINE**
CORONA SHIELDING SYSTEM, IN PARTICULAR EXTERNAL CORONA SHIELDING SYSTEM FOR AN ELECTRIC MACHINE
SYSTÈME ANTI-EFFLUVES, NOTAMMENT SYSTÈME ANTI-EFFLUVES EXTÉRIEUR, POUR MACHINE ÉLECTRIQUE

(30) Priorität: 28.02.2014 DE 102014203740
(43) Veröffentlichungstag der Anmeldung: 19.10.2016
(73) Patentinhaber: Siemens Aktiengesellschaft, 80333 München (DE)
(72) Erfinder: KLAUSSNER, Bernhard, 90408 Nürnberg (DE); LANG, Jiri, 90461 Nürnberg (DE); LANG, Steffen, 91352 Hallerndorf (DE); LITINSKY, Alexander, 40233 Düsseldorf (DE); SCHMIDT, Guido, 42799 Leichlingen (DE); SCHULZ-DROST, Christian, 90427 Nürnberg-Neunhof (DE); SCHÄFER, Klaus, 90455 Nürnberg (DE); STAUBACH, Christian, 45768 Marl (DE)
(86) Internationale Anmeldenummer: PCT/EP2015/053911
(87) Internationale Veröffentlichungsnummer: WO 2015/128367

(56) Entgegenhaltungen:
- WO-A1-03/107512
- WO-A1-2012/152262
- DE-A1-102010 009 462
- DE-A1-102010 009 462
- DE-A1-102010 032 949
- DE-A1-102011 075 425
- US-A1- 2013 260 139

## Beschreibung

Die Erfindung betrifft die Verwendung eines Glimmschutzsystems für eine elektrische Maschine, beispielsweise eine Hochspannungsmaschine, wie einem Generator zur Erzeugung von elektrischer Energie, einem elektrischen Motor, aber auch andere elektrische Betriebsmittel mit einer höheren Bemessungsspannung wie Trafos, Durchführungen, Kabel etc.

Es werden immer leistungsstärkere Maschinen, wie beispielsweise Generatoren, entwickelt, da die fortschreitende Technik immer höhere Leistungsdichten verlangt. Ein leistungsstarker Generator, wie beispielsweise ein Turbogenerator, weist insbesondere einen Ständer (Stator) mit einem Ständerblechpaket und einer Mehrzahl an Generatornuten, in denen sich die Generatorwicklung befindet.

Die Hauptisolierung dieser Wicklung gegen das Blechpaket ist ein elektrisch hoch beanspruchtes System. Im Betrieb entstehen hohe Spannungen, welche in dem Isoliervolumen zwischen dem auf Hochspannung befindlichen Leiterstab und dem auf Erdpotential liegendem Blechpaket abgebaut werden müssen. An den Kanten der Bleche im Blechpaket entstehen dabei Feldüberhöhungen, die ihrerseits Teilentladungen hervorrufen. Diese Teilentladungen führen bei Auftreffen auf das Isolationssystem lokal zu sehr starken Erhitzungen. Dabei werden die organischen Materialien des Isoliersystems inklusive die des Außenglimmschutzsystems sukzessive in niedermolekulare, volatile Produkte, beispielsweise in CO₂, zersetzt.

Ein wichtiger Bestandteil des Isolationssystems ist der so genannte Außenglimmschutz (AGS). Er wird bei größeren Generatoren und Elektromotoren direkt auf die Oberfläche der Wicklungsisolation appliziert. Der AGS besteht aktuell aus Ruß und Graphit-haltigen Bändern oder Lacken.

Da systembedingt vor allem die Grenzfläche zwischen AGS und Hauptisolation nicht vollständig porenfrei hergestellt werden kann, kommt es bei entsprechend hohen elektrischen Feldstärken im Isolationssystem zu einer entsprechend hohen elektrischen Teilentladungsaktivität, die den Außenglimmschutz im Betrieb im Laufe der Zeit komplett verbrennt und somit zu einer vorzeitigen Alterung der Isolierung und im schlimmsten Fall zu einem Erdschluss der elektrischen Maschine führt. Das entspricht einem irreparablen Komplettausfall der Maschine.

Der Außenglimmschutz muss einen gewissen Quadratwiderstand aufweisen, welcher in einem bestimmten Bereich liegt. Ist er zu gering, können die Blechpakete elektrisch kurzgeschlossen werden, was zu hohen induzierten Kreisströmen führen kann, welche sich über die Enden des Blechpakets und dem Außenglimmschutz erschließen und zu stromstarken Lichtbögen führen. Bei zu hohem Widerstand kann es wiederum zu Hochspannungsfunkenerosion kommen. Idealerweise wäre der Widerstand im Außenglimmschutzsystem einstellbar, so dass eine Anisotropie herstellbar wäre, die erhöhte Leitfähigkeit in radialer Richtung, also vom stromführenden Leiter zum Blechpaket hin, und ein erhöhter Widerstand, also geringe Leitfähigkeit, in Stabrichtung zeigt.

Aufgabe der vorliegenden Erfindung ist es daher, die Nachteile des Standes der Technik zu überwinden, ein stabiles Glimmschutzsystem zur Verfügung zu stellen.

Diese Aufgabe wird durch den Gegenstand der vorliegenden Erfindung, wie er in der Beschreibung und den Ansprüchen offenbart ist, gelöst.

Dementsprechend ist Gegenstand der vorliegenden Erfindung die Verwendung eines Glimmschutzsystems als Teil einer Hauptisolierung einer elektrischen Maschine, planare, teilentladungsresistente und elektrisch leitfähige Partikel als Füllstoff in einer polymeren Matrix zur Ausbildung von Strompfaden umfassend,
dadurch gekennzeichnet, dass
der Füllstoff zusätzlich sphärische, teilentladungsresistente und elektrisch leitfähige Partikel umfasst, durch die elektrische Leitfähigkeit in Querrichtung zu den Strompfaden der planaren Partikel gewährleistet ist.

Bevorzugt umfassen die Partikel einen teilentladungsresistenten Kern und einer teilentladungsresistenten Beschichtung, die leitfähig ist.

Der Begriff "teilentladungsresistent" bezieht sich dabei auf Materialien, die - beispielsweise - bei Teilentladungen an Luft gegen Oxidation resistent sind oder die ansonsten bei Teilentladungen stabil bleiben, wie Keramiken und/oder Gläser.

Die polymere Matrix ist beispielsweise ein Thermoplast, Duromer und/oder ein Elastomer.

Nach einer vorteilhaften Ausführungsform ist der teilentladungsresistente Kern aus einem keramischen oder glasartigen Material, was vorzugsweise eine geringe Dichte aufweist und vorzugsweise Glimmer, Quarzmehl, Aluminiumoxid oder Glasplättchen ist.

Bei einer planaren Struktur der Partikel wird eine verbesserte Kontaktierung der leitfähigen Partikel untereinander erreicht. Bevorzugtermaßen wird das, die Partikel beschichtende, Material ein Metalloxid sein und aus der Gruppe Zinnoxid, Zinkoxid, Zinkstannat, Titandioxid, Bleioxid oder nichtoxidisch Siliziumcarbid umfassend, ausgewählt. Das Dotierungselement wird bevorzugt aus der Gruppe: Antimon, Indium, Cadmium ausgewählt.

Ferner ist es bevorzugt, dass die Partikelmassenkonzentration der Partikel in der Trägermatrix derart gewählt wird, dass das Glimmschutzmaterial oberhalb der Perkulationsschwelle ist. Hierbei ist es bevorzugt, dass die Partikelmassenkonzentration der Partikel bei mehr als 15 Gew% liegt. Ab dieser bestimmten Partikelmassenkonzentration in der Trägermatrix befindet sich der Verbundwerkstoff oberhalb der Perkulationsschwelle und der Oberflächenwiderstand des Glimmschutzmaterials ändert sich kaum mit steigender Partikelmassenkonzentration. Dadurch unterliegt das Glimmschutzmaterial kaum Schwankungen im Oberflächenwiderstand, der dadurch gut reproduzierbar ist.

Ein besonderer Aspekt der Erfindung ist die Mischung von sphärischen und planaren Füllstoff-Partikeln. Aus der DE 10 2010 009 462.5 ist bekannt, dass zur Herstellung des Außenglimmschutzes planare plättchenförmige Partikel eingesetzt werden, die durch ihre Ausrichtung während des Herstellungsprozesses und deren leitfähige Beschichtung Leitfähigkeitspfade schaffen, entlang derer die Leitfähigkeit hoch und der Widerstand gering ist. Nachteilig daran ist, dass die Leitfähigkeit senkrecht dazu, also in radialer Richtung, wo die plättchenförmigen Partikel nur eine sehr geringe Ausdehnung haben, ziemlich gering ist. Wie oben erwähnt, wäre jedoch die Leitfähigkeit gerade in dieser radialen Richtung erwünscht.

Allgemeine Erkenntnis der vorliegenden Erfindung ist, dass zu den hervorragenden Eigenschaften des Glimmschutzes mit beschichteten planaren Partikeln, wie beispielsweise aus der DE 10 2010 009 462.5 bekannt, durch Zugabe von sphärischen Partikeln gezielt eine Leitfähigkeit in Querrichtung zu den Plättchen einstellbar ist.

Bevorzugt werden die Partikel in Mikrogröße eingesetzt, beispielsweise haben die Plättchen eine Breite und Länge im Mikrometerbereich, also beispielsweise im Bereich von 1 bis 300 µm, insbesondere von 1 bis 100 µm und insbesondere bevorzugt von 1 bis 40 µm, wohingegen ihr Durchmesser in Dickenrichtung im Nanometerbereich also zwischen 50 und 1000 nm liegt, insbesondere im Bereich von 100nm bis 1000 nm. Die sphärischen Partikel haben beispielsweise einen Durchmesser im Bereich von 0,5 bis 50µm, insbesondere von 1 bis 10µm.

Durch Zugabe von globularen, also sphärischen Füllstoffen zu planaren oder stäbchenförmigen Füllstoffen verschieben sich die Perkolationsschwellen der drei Raumrichtungen zu deutlich niedrigeren Füllstoffkonzentrationen. Dadurch und durch die Tatsache, dass globulare Füllstoffe eine geringere spezifische Oberfläche besitzen als planare Partikel, wird die absolute Fläche an Grenzflächen im Verbundwerkstoff deutlich reduziert, wobei das System dennoch überperkulär vorliegt. Dadurch ist es nun erstmals möglich, dass solche Glimmbänder unter Temperatureintrag aufschmelzen und im Falle einer sich überlappenden Wicklung sehr gut miteinander verschmelzen und kaum ein Kontaktwiderstand durch die Überlappung entsteht. Gleichzeitig ist und bleibt dieses System sehr reproduzierbar, da auch so der elektrische Widerstand überperkulär eingestellt werden kann.

Beispielsweise liegen die planaren Partikel im Verhältnis zu den sphärischen Partikeln ungefähr wie 3:1 vor.
- Durch die Zugabe von globularen Füllstoffen zu planaren Füllstoffen wird die elektrische Leitfähigkeit senkrecht zu den gerichteten Füllstoffplättchen deutlich erhöht, da sich die Kügelchen zwischen den Plättchen einlagern. Dadurch kann der anisotrope elektrische Widerstand der Glimmschicht in gewissen Bereichen angepasst werden.
- Wenn die globularen Partikel ebenfalls aus einem dotierten Metalloxid hergestellt werden, sind sie, wie die bereits aus der früheren Anmeldung DE 10 2010 009 462.5 bekannten planaren Partikel, ebenfalls resistent gegenüber Teilentladungen. Dadurch wird die Lebensdauer der elektrischen Maschine deutlich erhöht, bzw. kann mit einer höheren Leistung betrieben werden.
- Die generelle Leitfähigkeit von solchen globularen Füllstoffen kann durch die Dotierung des Metalloxides eingestellt werden (analog zu den planaren Füllstoffen).

Beide Füllstoffe besitzen bevorzugt ein leichtes Trägersubstrat.
- Die planaren Partikel Glimmer, die globularen Partikel Quarzmehl. Dadurch wird sichergestellt, dass die so hergestellten Füllstoffe eine relativ geringe Dichte besitzen und sich so während der Verarbeitung nicht absetzen, denn die funktionale Beschichtung auf den erwähnten Substraten besteht aus dotierten Metalloxiden, z.B. Antimon dotiertes Zinnoxid, was eine Dichte von 6,9 g/cm³ besitzt. Die fertigen Füllstoffe, mit dem jeweiligen leichten Substrat besitzen resultierend nur eine Dichte von - beispielsweise - 3,5 g/cm³.
- Die planare Geometrie, sowie die Ausrichtung des Füllstoffes im Glimmschutz senkrecht zur Feldbelastung verlängert deutlich den Erosionsweg durch den Glimmschutz im Vergleich zu einem Glimmschutz, der nur aus globularen Füllstoffen besteht. Deshalb ist die Menge der den plättchenförmigen Partikeln zugesetzten sphärischen Partikel in dem Spannungsfeld auszuwählen zwischen der Erhöhung des Erosionsweges durch möglichst vollständige plättchenförmige Partikel und Einstellung einer anisotropen Leitfähigkeit durch globulare Partikel.

Die Erfindung betrifft ein Glimmschutzsystem für eine elektrische Maschine, beispielsweise eine Hochspannungsmaschine, wie einen Generator zur Erzeugung von elektrischer Energie, einem elektrischen Motor aber auch andere elektrische Betriebsmittel mit einer höheren Bemessungsspannung wie Trafos, Durchführungen, Kabel etc. Das Glimmschutzsystem zeichnet sich durch eine Füllstoff-Mischung aus, in der sowohl planare als auch sphärische Partikel vorkommen. Damit ist die elektrische Leitfähigkeit, die bei Vorliegen von nur planaren Partikeln in zwei Raumrichtungen gut, in die Dritte aber sehr schlecht ist, gezielt anisotrop einstellbar.

## Patentansprüche

1. Verwendung eines Glimmschutzsystems als Teil einer Hauptisolierung einer elektrischen Maschine, planare, teilentladungsresistente und elektrisch leitfähige Partikel als Füllstoff in einer polymeren Matrix zur Ausbildung von Strompfaden umfassend,
**dadurch gekennzeichnet, dass**
der Füllstoff zusätzlich sphärische, teilentladungsresistente und elektrisch leitfähige Partikel umfasst, durch die elektrische Leitfähigkeit in Querrichtung zu den Strompfaden der planaren Partikel gewährleistet ist.

2. Verwendung nach Anspruch 1,
**dadurch gekennzeichnet, dass**
die Partikelmassenkonzentration in der Matrix des Glimmschutzsystems oberhalb der Perkolationsschwelle liegt.

3. Verwendung nach Anspruch 2,
**dadurch gekennzeichnet, dass**
die Partikelmassenkonzentration in der Matrix des Glimmschutzsystems bei mehr als 15 Gew% liegt.

4. Verwendung nach einem der vorhergehenden Ansprüche,
**dadurch gekennzeichnet, dass**
die Ausmaße der planaren teilentladungsresistenten und elektrisch leitfähigen Partikel eine Breite und Länge im Mikrometerbereich mit eine Dicke im Nanometerbereich kombiniert aufweisen.

5. Verwendung nach einem der vorhergehenden Ansprüche,
**dadurch gekennzeichnet, dass**
die planaren teilentladungsresistenten und elektrisch leitfähigen Partikel eine Breite und Länge im Bereich von 1µm bis 300 µm aufweisen.

6. Verwendung nach einem der vorhergehenden Ansprüche,
**dadurch gekennzeichnet, dass**
die planaren teilentladungsresistenten und elektrisch leitfähigen Partikel eine Dicke im Bereich zwischen 50nm und 1000 nm aufweisen.

7. Verwendung nach einem der vorhergehenden Ansprüche,
**dadurch gekennzeichnet, dass**
die sphärischen Partikel einen Durchmesser im Bereich von 0,5 bis 50 µm haben.

8. Verwendung nach einem der vorhergehenden Ansprüche,
**dadurch gekennzeichnet, dass**
das Glimmschutzsystem stäbchenförmige Partikel umfasst.

9. Verwendung nach einem der vorhergehenden Ansprüche,
**dadurch gekennzeichnet, dass**
die polymere Matrix aus einem Duromer, einem Thermoplast und/oder einem Elastomer herstellbar ist.

10. Verwendung nach einem der vorstehenden Ansprüche,
**dadurch gekennzeichnet, dass**
die Partikel einen teilentladungsresistenten Kern mit einer teilentladungsresistenten, elektrisch leitfähigen Beschichtung umfassen.

11. Verwendung nach einem der vorstehenden Ansprüche,
**dadurch gekennzeichnet, dass**
das Glimmschutzsystem Partikel umfasst, deren teilentladungsresistenter Kern aus einem Material ist, das ausgewählt ist aus der Gruppe umfassend Glimmer, Quarzmehl, Aluminiumoxid oder Glasplättchen.

12. Verwendung nach einem der vorstehenden Ansprüche,
**dadurch gekennzeichnet, dass**
das Glimmschutzsystem Partikel mit metalloxidischer Beschichtung umfasst.

13. Verwendung nach Anspruch 12,
**dadurch gekennzeichnet, dass**
das Metalloxid dotiert vorliegt.

14. Verwendung nach einem der vorstehenden Ansprüche,
**dadurch gekennzeichnet, dass**
die sphärischen Partikel und die planaren Partikel des Füllstoffs ungefähr im Verhältnis 1:3 vorliegen.

15. Elektrische Maschine, eine Hauptisolierung mit einem Glimmschutzsystem, das durch eine Verwendung nach einem der Ansprüche 1 bis 14 erhältlich ist, umfassend.

## Claims

1. Use of a corona shielding system as part of a main insulation of an electrical machine, comprising planar particles that are resistant to partial discharges and electrically conductive, as filler in a polymeric matrix for forming current paths,
**characterized in that**
the filler additionally comprises spherical particles that are resistant to partial discharges and electrically conductive, and by means of which the electrical conductivity in the transverse direction in relation to the current paths of the planar particles is ensured.

2. Use according to Claim 1,
**characterized in that**
the particle mass concentration in the matrix of the corona shielding system is above the percolation threshold.

3. Use according to Claim 2,
**characterized in that**
the particle mass concentration in the matrix of the corona shielding system lies above 15% by weight.

4. Use according to any of the preceding claims,
**characterized in that**
the extents of the planar particles that are resistant to partial discharges and electrically conductive have a width and length in the micrometre range in combination with a thickness in the nanometre range.

5. Use according to any of the preceding claims,
**characterized in that**
the planar particles that are resistant to partial discharges and electrically conductive have a width and length in the range of 1 µm to 300 µm.

6. Use according to any of the preceding claims,
**characterized in that**
the planar particles that are resistant to partial discharges and electrically conductive have a thickness in the range between 50 nm and 1000 nm.

7. Use according to any of the preceding claims,
**characterized in that**
the spherical particles have a diameter in the range of 0.5 to 50 µm.

8. Use according to any of the preceding claims,
**characterized in that**
the corona shielding system comprises rod-like particles.

9. Use according to any of the preceding claims,
**characterized in that**
the polymeric matrix is able to be produced from a thermoset, a thermoplastic and/or an elastomer.

10. Use according to any of the preceding claims,
**characterized in that**
the particles comprise a core that is resistant to partial discharges with a coating that is resistant to partial discharges and is electrically conductive.

11. Use according to any of the preceding claims,
**characterized in that**
the corona shielding system comprises particles whose core that is resistant to partial discharges is of a material which is selected from the group encompassing mica, silica flour, alumina or glass platelets.

12. Use according to any of the preceding claims,
**characterized in that**
the corona shielding system comprises particles having a metal-oxide coating.

13. Use according to Claim 12,
**characterized in that**
the metal oxide is present in doped form.

14. Use according to any of the preceding claims,
**characterized in that**
the spherical particles and the planar particles of the filler are present approximately in a ratio of 1:3.

15. Electrical machine comprising a main insulation with a corona shielding system which is obtainable by a use according to any of Claims 1 to 14.

## Revendications

1. Utilisation d'un système anti-effluves en tant que partie d'une isolation principale d'une machine électrique, comprenant des particules planaires, résistant à la décharge partielle et électriquement conductrices en tant que matière de charge dans une matrice polymère pour former des trajets de courant,
**caractérisée en ce que** la matière de charge comprend en outre des particules sphériques, résistant à la décharge partielle et électriquement conductrices, par lesquelles la conductivité électrique est assurée en direction transversale par rapport aux trajets de courant des particules planaires.

2. Utilisation selon la revendication 1,
**caractérisée en ce que** la concentration en masse des particules dans la matrice du système anti-effluves est supérieure au seuil de percolation.

3. Utilisation selon la revendication 2,
**caractérisée en ce que** la concentration en masse des particules dans la matrice du système anti-effluves est supérieure à 15 % en poids.

4. Utilisation selon l'une des revendications précédentes,
**caractérisée en ce que** les dimensions des particules planaires, résistant à la décharge partielle et électriquement conductrices comprennent une largeur et une longueur de l'ordre du micron combinées à une épaisseur de l'ordre du nanomètre.

5. Utilisation selon l'une des revendications précédentes,
**caractérisée en ce que** les particules planaires, résistant à la décharge partielle et électriquement conductrices ont une largeur et une longueur de 1 µm à 300 µm.

6. Utilisation selon l'une des revendications précédentes,
**caractérisée en ce que** les particules planaires, résistant à la décharge partielle et électriquement conductrices ont une épaisseur de 50 nm à 1000 nm.

7. Utilisation selon l'une des revendications précédentes,
**caractérisée en ce que** les particules sphériques ont un diamètre de 0,5 à 50 µm.

8. Utilisation selon l'une des revendications précédentes,
**caractérisée en ce que** le système anti-effluves comprend des particules en forme de bâtonnet.

9. Utilisation selon l'une des revendications précédentes,
**caractérisée en ce que** la matrice de polymère peut être constituée d'une matière plastique thermodurcissable, d'un thermoplastique et/ou d'un élastomère.

10. Utilisation selon l'une des revendications précédentes,
**caractérisée en ce que** les particules ont un noyau résistant à la décharge partielle doté d'un revêtement électriquement conducteur résistant à la décharge partielle.

11. Utilisation selon l'une des revendications précédentes,
**caractérisée en ce que** le système anti-effluves comprend des particules dont le noyau résistant à la décharge partielle est constitué d'un matériau choisi dans le groupe comprenant du mica, de la poudre de quartz, de l'oxyde d'aluminium ou des lamelles de verre.

12. Utilisation selon l'une des revendications précédentes,
**caractérisée en ce que** le système anti-effluves comprend des particules comportant un revêtement d'oxyde de métal.

13. Utilisation selon la revendication 12,
**caractérisé en ce que** l'oxyde de métal est dopé.

14. Utilisation selon l'une des revendications précédentes,
**caractérisée en ce que** les particules sphériques et les particules planaires de la matière de charge sont présentes dans un rapport d'environ 1 : 3.

15. Machine électrique, comprenant une isolation principale comportant un système anti-effluves qui peut être obtenu par une utilisation selon l'une des revendications 1 à 14.
